# EUROPÄISCHE PATENTSCHRIFT

(11) **EP 0 626 739 B1**
(45) Veröffentlichungstag und Bekanntmachung des Hinweises auf die Patenterteilung: **10.10.2001**
(21) Anmeldenummer: 94100830.2
(22) Anmeldetag: 21.01.1994
(51) Int. Cl.: H01R 43/28, H01R 43/01, H05K 13/06

(54) **Leitungsverlegewerkzeug**
Laying tool for electrical wires
Outil de pose de conducteurs électriques

(30) Priorität: 20.04.1993 DE 4312777
(43) Veröffentlichungstag der Anmeldung: 30.11.1994
(73) Patentinhaber: Vossloh Schwabe GmbH, 73660 Urbach (DE)
(72) Erfinder:
(74) Vertreter: Rüger, Rudolf, Dr.-Ing.

(56) Entgegenhaltungen:
- EP-A- 0 109 735
- US-A- 4 271 573
- US-A- 4 461 061

## Beschreibung

Die Erfindung betrifft ein Werkzeug zum Verlegen und gegebenenfalls Ablängen von elektrischen Leitungen mit den Merkmalen des Oberbegriffes des Patentanspruchs 1.

Leitungsverlegewerkzeuge dieser Art sind beispielsweise aus der DE-OS 36 06 059, DE-OS 36 11 805 und DE-OS 38 20 636 bekannt. Sie finden insbesondere zur Herstellung von Kabelbäumen Verwendung, doch können sie auch für die Verdrahtung von Maschinenbauteilen usw. eingesetzt werden. Der Verlegefinger wird mit der Mündung seines Führungskanales an eine bestimmte Anschlußstelle gebracht an der die aus dem Führungskanal austretende Leitung positioniert und kontaktiert wird. Das Abschneiden der Leitung erfolgt hierbei in einem eigenen sogenannten Ablängmodul des Werkzeuges, der dem eigentlichen Verlegefinger vorgeschaltet ist und in einem beträchtlichen Abstand zu der Mündungsöffnung des Leitungsführungskanals angeordnet ist.

Mit diesen Werkzeugen ist deshalb ein Abtrennen der Leitung unmittelbar an der kontaktierten Anschlußstelle nicht möglich. Dies ist aber insbesondere dann erwünscht, wenn die Anschlußstelle mit einem Schneidklemmkontakt ausgebildet ist, d.h. der Leitungsanschluß nach der sogenannten Schneidklemmtechnik erfolgt.

Bei einem aus der US-A 4,461,061 bekannten Leitungsverlegewerkzeug ist der Verlegefinger nach Art eines Röhrchens ausgebildet, durch das die anzuschließende Leitung in eine an der Stirnseite eines benachbarten Druckgliedes vorgesehene Nut eingeführt wird. Die Ablängmittel für die Leitung weisen eine bezüglich des Druckgliedes schwenkbar gelagerte Messerklinge auf, die mit der die Leitung aufnehmenden Nut an der Stirnseite des Druckgliedes zusammenwirkt, wobei die Nut das Gegenmesser bildet. Die seitliche Schwenkbewegung der Messerklinge bezüglich des Druckglieds bietet bei solchen Anschlussklemmen für die Schneidklemmtechnik Schwierigkeiten, bei denen enge Platzverhältnisse vorliegen.

Aufgabe der Erfindung ist es deshalb, ein Leitungsverlegewerkzeug zu schaffen, daß sich bei einfachem Aufbau insbesondere für den Leitungsanschluß nach der Schneidklemmtechnik eignet, wobei an der jeweiligen Anschlußstelle wahlweise die Leitung abgeschnitten oder nach der Kontaktierung weitergeführt werden kann.

Diese Aufgabe wird durch ein Werkzeug mit den im Anspruch 1 genannten Merkmalen gelöst.

Das Druckglied erlaubt es, bei entsprechend positioniertem Verlegefinger das aus der Mündungsöffnung des Führungskanals des Verlegefingers austretende Leitungsteil unmittelbar in den Schneidklemmschlitz einer als Schneidklemmkontakt ausgebildeten Kontaktstelle einzudrücken. Da die Abschneidemittel für die Leitung in der Nähe der Mündungsöffnung des Führungskanals längsverschieblich angeordnet sind, wird beim Abschneiden der Leitung an der Kontaktstelle ein sehr kurzes freies Leitungsende erzeugt, das durch geeignete Maßnahmen im Bereiche des Schneidklemmkontaktes dort berührungssicher aufgenommen werden kann, ohne daß zusätzliche Maßnahmen zur Isolation etc. erforderlich wären.

Es ergeben sich sehr günstige Platzverhältnisse, da das Druckglied unmittelbar an dem Verlegefinger längsverschieblich gelagert ist, wobei die Messerklinge an das Druckglied anschließend an dem Verlegefinger und/oder dem Druckglied ebenfalls verschieblich gelagert sein kann. Das Druckglied kann selbst einteilig oder mehrteilig sein. In dem letzteren Fall kann an der jeweiligen Anschlußstelle beidseitig des Schneidklemmschlitzes die Leitungsführung individuell beeinflußt werden, indem die Leitung beispielsweise anschließend an den Schneidklemmschlitz etwas abgewinkelt oder abgebogen wird.

In einer bevorzugten Ausführungsform weist das Druckglied im Bereiche der Druckfläche einen auf die aus der Mündung des Führungskanals austretende Leitung ausgerichteten Steg auf, dessen Breite quer zur Leitungsrichtung im wesentlichen kleiner oder gleich dem Durchmesser der Leitung ist. Der Steg ist zweckmäßigerweise wenigstens einseitig durch Bereiche größerer Breite begrenzt. Auf diese Weise kann sichergestellt werden, daß das Leitungsstück beim Eindrücken in den Schneidklemmschlitz über die erforderliche Länge einwandfrei abgestützt ist, so daß es beim Eindrückvorgang nicht ausweichen kann. Gegebenenfalls kann auf einer Seite des Steges auch eine vorspringende Nase angeordnet sein, die gegebenenfalls für sich beweglich ausgebildet sein kann. Damit kann die Leitung im Bereiche des Austritts aus der Mündungsöffnung des Führungskanals erforderlichenfalls abgewinkelt werden und zwar unabhängig davon, ob sie an der jeweiligen Kontaktstelle abgeschnitten wird oder nicht.

In der Regel ist es von Vorteil, wenn der Steg beidseitig durch Bereiche größerer Breite begrenzt ist, von denen einer sich an eine die Mündungsöffnung des Führungskanals enthaltende Fläche des Verlegefingers anschließt, so daß die Leitung unmittelbar beim Austritt aus der Mündungsöffnung des Führungskanals beim Verlegevorgang schon die notwendige Abstützung findet.

Die Abschneidmittel weisen in einer zweckmäßigen Ausführungsform ein an dem Verlegefinger längsverschieblich geführtes Messer mit einer Messerklinge auf, dessen Messerklinge oberhalb eines im wesentlichen horizontalen Teiles des Führungskanals beweglich angeordnet ist. Dabei ist es mit Rücksicht auf die Erzielung guter Schnittverhältnisse von Vorteil, wenn die Messerklinge wenigstens eine schräg zu der zugeordneten Wand des Führungskanals verlaufende Schneidkante aufweist und mit einer auf die zugeordnete Wand des Führungskanals aufpressbaren Schneidkantenspitze ausgebildet ist, die in der Nähe der Mündung des Führungskanales liegt. Die Wand des Führungskanals bildet damit unmittelbar das Gegenmesser oder den Amboß, gegen das bzw. den die Leitung abgeschnitten wird. Die Abschneidstelle kann dabei unmittelbar neben der Führungskanalmündung liegen. Weil der Amboßschnitt unmittelbar in dem Führungskanal stattfindet, ergibt sich der Vorteil, daß praktisch kein seitlicher Platzbedarf erforderlich ist. Nach längerer Betriebszeit muß lediglich die Schneidkante des Messers nachgeschliffen werden. Der Verschleiß des Verlegefingers ist unbedeutend; erforderlichenfalls kann der Bereich der Wandung des Führungskanals, der als Gegenmesser oder Amboß für die Schneidklinge dient, aus einem für diese Zweckbestimmung besonders geeigneten Material bestehen und sogar austauschbar etwa an einem Einsatzteil ausgebildet sein.

In der Zeichnung ist ein Ausführungsbeispiel des Gegenstandes der Erfindung dargestellt. Es zeigen:
- Fig. 1: Ein Leitungsverlegewerkzeug gemäß der Erfindung in einer Seitenansicht teilweise aufgeschnitten unter Veranschaulichung des Zustandes beim Verlassen einer kontaktierten Anschlußstelle,
- Fig. 2: den Verlegefinger des Leitungsverlegewerkzeugs nach Fig. 1 in einer stirnseitigen Ansicht von unten,
- Fig. 3: den Verlegefinger des Werkzeugs nach Fig. 1 geschnitten längs der Linie III - III der Fig. 1 in einer Draufsicht,
- Fig. 4: den Verlegefinger des Leitungsverlegewerkzeugs nach Fig. 1 in einer entsprechenden Darstellung unter Veranschaulichung des Zustands nach dem Eindrücken der Leitung in den Schneidklemmschlitz einer Anschlußklemme,
- Fig. 5: den Verlegefinger nach Fig. 4 in einer entsprechenden Darstellung unter Veranschaulichung des Zustands beim Abschneiden der Leitung.

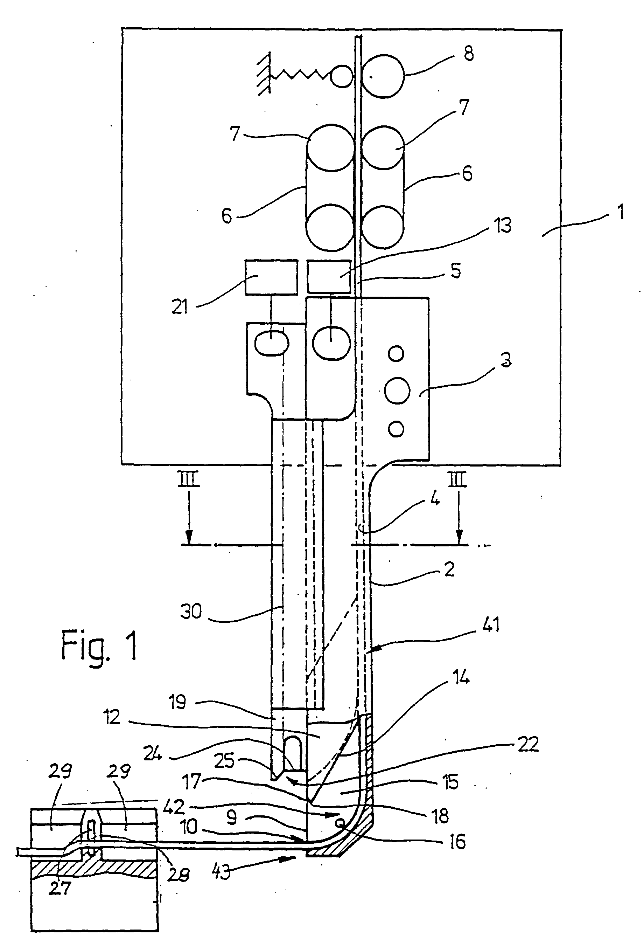

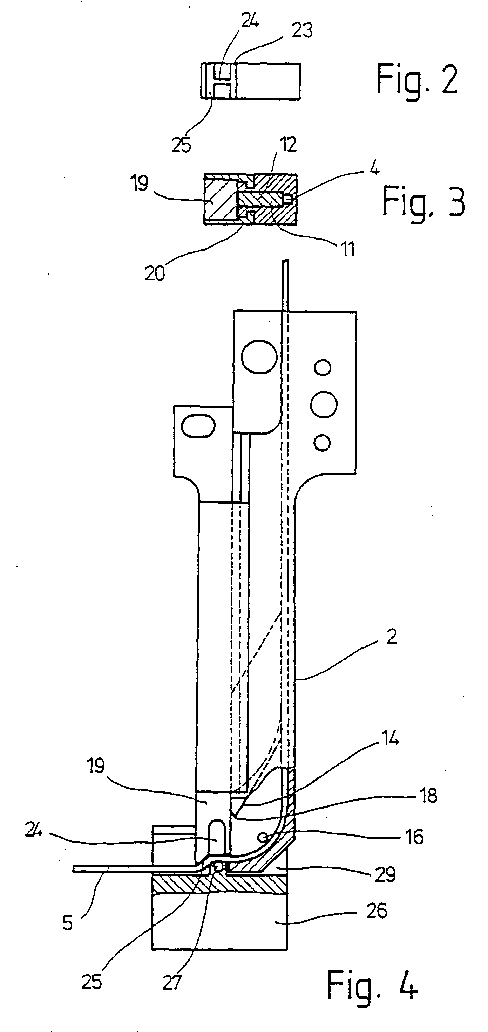

Das Leitungsverlegewerkzeug weist eine in Fig. 1 schematisch dargestelltes Gehäuse 1 auf, das zur Befestigung an einem Industrieroboter eingerichtet ist. An dem Gehäuse 1 sitzt an der Arbeitsseite unten vorragend ein vertikaler Verlegefinger 2 von im wesentlichen rechteckiger schmaler Querschnittsgestalt (Fig. 3), der in der Regel aus Stahl hergestellt ist. Der Verlegefinger 2 ist bei 3 an dem Gehäuse 1 befestigt; in ihm ist ein Führungskanal 4 für eine Leitung 5 ausgebildet, die von einer nicht weiter dargestellten Spule zugeführt wird. In dem Gehäuse sind dem Verlegefinger 2 vorgeschaltet Vorschubmittel für die Leitung 5 angeordnet, die durch zwei jeweils durch einen Vorschubriemen 6 miteinander verbundene programmgemäß gesteuerte Vorschubrollenpaare 7 angedeutet sind. Außerdem ist eine bei 8 angedeutete gesteuerte Klemmvorrichtung für die Leitung 5 vorhanden.

Der Führungskanal 4 ist im wesentlichen L-förmig gestaltet. Er weist einen im wesentlichen vertikalen Abschnitt 41 (Fig. 1) auf, an den sich unten über einen Bogen von 90° ein kreisbogenförmig gekrümmter Abschnitt 42 anschließt und der seinerseits zu einem kurzen, im wesentlichen horizontalen, Abschnitt 43 führt, von dem aus die Leitung 5 durch eine in einer ebenen Vertikalfläche 9 des Verlegefingers 2 liegende Mündungsöffnung 10 nach außen tritt. In einer parallelflankig begrenzten Nut 11 des Verlegefingers (Fig. 3) ist eine im Querschnitt rechteckige Messerklinge 12 längsverschieblich geführt, die einenends mit einer bei 13 in Fig. 1 angedeuteten programmgesteuerten Stellvorrichtung gekuppelt und anderenends mit einer schrägverlaufenden Schneidkante 14 versehen ist. Die Schneidkante 14, die sich über den größten Teil der Breite der Messerklinge 12 erstreckt, liegt in einer schlitzartigen Aussparung 15 des Verlegefingers 2 oberhalb der Mündungsöffnung 10 des Führungskanals 4, in der die Leitung 5 durch einen Führungsstift 16 zusätzlich geführt ist. Sie bildet gemeinsam mit einer kurzen Schneidkante 16, mit der sie einen spitzen Winkel einschließt, eine Schneidenspitze 18, die in unmittelbarer Nähe der Mündungsöffnung 10 des Führungskanals 4 innerhalb der Aussparung 15 liegt.

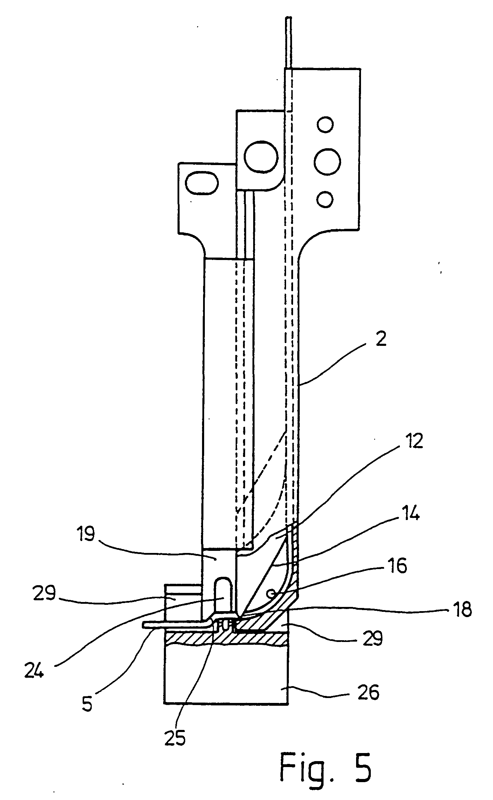

Die Messerklinge 12 ist somit oberhalb des bogenförmigen und des horizontalen Abschnittes 42, 43 des Führungskanals 4 angeordnet, derart, daß ihre Schneidenspitze 18 mit der als Gegenmesser oder Amboß wirkenden unteren Bodenwand des horizontalen Führungskanalabschnittes 43 zusammenwirken kann, wie dies insbesondere aus Fig. 5 zu ersehen ist.

An dem Verlegefinger 2 ist außerdem seitlich unmittelbar an die Messerklinge 12 anschließend ein nach Art eines Stempels ausgebildetes Druckglied 19 über eine Nutenführung 20 (Fig. 3) längsverschieblich geführt. Das Druckglied 19 kann durch eine programmgesteuerte bei 21 angedeutete Betätigungsvorrichtung in Vertikalrichtung bezüglich des Verlegefingers 2 wahlweise vor- und zurückgeschoben werden.

Das Druckglied 19 ist an seiner Stirnseite mit einer Druckfläche 22 ausgebildet, die sich über deren größten Teil in einer horizontalen Ebene erstreckt und die dazu bestimmt ist, auf der aus der Mündungsöffnung 10 austretenden Leitung 5 aufzuliegen und diese abzustützen.

Wie insbesondere aus Fig. 2 zu ersehen, schließt sich an die vertikale Führungsfläche des Verlegefingers 2 zunächst ein Druckflächenabschnitt 23 an, der im wesentlichen rechteckig ist und die gleiche Breite wie der Verlegefinger 2 aufweist. An diesen schmalen Druckflächenbereich 23 grenzt mittig ein schmaler rechteckiger Steg 24 an, auf den eine nach unten schräg vorragende Nase 25 folgt, die wiederum etwa die Breite des Verlegefingers 2 aufweist.

Wegen der bogenförmigen Krümmung des Abschnittes 42 und der Eigenelastizität der Leitung 5 würde sich diese beim Austritt aus der Mündungsöffnung 10 nach Art einer Feder nach oben einrollen. Dies zu verhindern und bei dem Kontaktiervorgang die Leitung neben dem Schneidklemmkontakt nach unten zu drücken, ist Aufgabe der Nase 25.

In Fig. 1 ist der Zustand dargestellt, in dem die aus der Mündungsöffnung 10 des Verlegefingers 2 austretende Leitung in einem vorhergehenden Schritt an einer Anschlußstelle in einer Anschlußklemme 26 kontaktiert ist. Die Anschlußklemme 26 weist beidseitig eines mit einem Schneidklemmschlitz 27 versehenen Schneidklemmkontaktes 28 jeweils eine im Querschnitt rechteckige geradflächig begrenzte nutartige Vertiefung auf.

Nach dem nachfolgenden, anhand von Fig. 4 beschriebenen, Einpressen der Leitung 5 in den Schneidklemmschlitz 27 der Anschlußklemme 26 durch das Druckglied 19 ist das Druckglied 19 kurzzeitig in die in Fig. 1 dargestellte obere Stellung gefahren, in der es das Ausfahren des Verlegefingers 2 aus der rechten nutartigen Vertiefung 29 der Anschlußklemme 26 nicht behindert. Sowie der Verlegefinger 2 von der kontaktierten Anschlußklemme 26 freigekommen ist, geht das Druckglied 29 programmgesteuert wieder nach unten in eine Stellung, in der die Druckfläche 29 auf der aus der Mündungsöffnung 10 austretenden Leitung 5 aufliegt und deren Einrolltendenz kompensiert.

Mit in dieser Stellung stehenden Druckglied 19 wird der Verlegefinger 2 nun lagerichtig oberhalb einer weiteren Anschlußklemme 26 positioniert, derart, daß er oberhalb der zugeordneten nutartigen Vertiefung 29 steht.

Nunmehr werden der Verlegefinger 2 und das Druckglied 19 abgesenkt; sie treten in die nutartige Vertiefung 29 der Anschlußklemme 26 ein, mit der Folge, daß das aus der Mündungsöffnung 10 austretende Leitungsstück nunmehr in den Schneidklemmschlitz 27 des Schneidklemmkontaktes 28 eingedrückt wird. Es ergibt sich damit der in Fig. 4 dargestellte Zustand.

Dabei ist das Leitungsstück auf beiden Seiten des Schneidklemmschlitzes 27 durch den Bereich 23 und die Nase 25 abgestützt, während die Abstützung im Bereiche des Schneidklemmschlitzes selbst über die Stirnfläche des Steges 24 erfolgt, dessen Breite quer zur Leitungsrichtung schmäler oder höchstens gleich oder etwas größer als bzw. dem Durchmesser der Leitung 5 bemessen ist. Die Nase 25 drückt die Leitung 5 auf den Boden der zugeordneten nutartigen Vertiefung 29. Sie kann in einer abgewandelten Ausführungsform auch getrennt für sich steuerbar sein, wozu dann das Druckglied 19 in zwei aneinander verschieblich gelagerte und getrennt ansteuerbare Teile aufgeteilt ist, wie dies in Fig. 1 durch eine Trennlinie bei 30 strichpunktiert angedeutet ist.

Anschließend an das in Fig. 4 veranschaulichte Einpressen der Leitung 5 in den Schneidklemmschlitz 27 wird die Messerklinge 12 in die Schneidstellung nach Fig. 5 bewegt, in der ihre Schneidenspitze 18 im Zusammenwirken mit der Bodenwand des horizontalen Abschnittes 43 des Führungskanals 4 die Leitung 5 unmittelbar neben dem Schneidklemmkontakt 28 abschneidet.

Erforderlichenfalls kann an dieser Stelle die Bodenwand des horizontalen Führungskanalabschnittes 43 noch nach unten zusätzlich abgesenkt sein, derart, daß sich auch auf dieser Seite des Schneidklemmkontaktes 28 eine nach unten gerichtete Orientierung des abgeschnittenen Endes der Leitung 5 ergibt. Mit anderen Worten, es kann auch hier die gleiche Wirkung wie die der Nase 25 erzielt werden.

Nach Beendigung des Abschneidevorganges wird der Verlegefinger 2 wieder angehoben; das Druckglied 19 und die Messerklinge 12 gehen in ihre Ruhestellung nach Fig. 1 zurück und der Leitungsverlegevorgang wird fortgesetzt.

Der Verlegefinger 2 ist an seinem unteren Ende im Bereiche der dem Führungsstift 16 gegenüberliegenden "Ecke" abgeschrägt; er kann an der entsprechenden vorderen Stirnkante auch abgerundet oder keilförmig gestaltet sein. Sinn dieser Maßnahme ist es, beim Leitungsverlegevorgang das Durchfahren von Leitungshalterungselementen zu erleichtern, die Rückhalteelemente aufweisen, welche elastisch ausweichen können und sich nach dem Durchfahren des Verlegefingers wieder selbsttägig schließen.

## Patentansprüche

1. Werkzeug zum Verlegen und gegebenenfalls Ablängen von elektrischen Leitungen, mit einem zur Verbindung mit Verlegemitteln, beispielsweise einem Industrieroboter, eingerichteten Gehäuse (1) mit einem auf einer Arbeitsseite des Gehäuses angeordneten Verlegefinger (2), in dem ein eine seitliche Mündung aufweisender Führungskanal (4) für eine Leitung (5) ausgebildet ist, sowie mit Vorschub- und Ablängmitteln für die Leitung, wobei das Werkzeug ein in der Nähe der Mündung (10) des Führungskanals angeordnetes Druckglied (19) für die aus der Mündung des Führungskanals austretende Leitung aufweist, das quer zu der Achsrichtung des Führungskanals im Mündungsbereich beweglich gelagert und mit eigenen Stellmitteln (21) gekuppelt ist, durch die es zwischen eine von der Mündung entfernten Stellung und einer Arbeitsstellung verstellbar ist,
**dadurch gekennzeichnet,**
**dass** das Druckglied (19) in der Arbeitsstellung mit einer Druckfläche (22) die Mündungsberandung des Führungskanals (4) überragt oder mit der Oberseite der Mündungsberandung fluchtet,
**dass** das Druckglied (19) an eine die Mündungsöffnung (10) enthaltende Fläche (9) anschließend, an dem Verlegefinger (2) längsverschieblich geführt ist und
**dass** die verschiebbar geführten Ablängmittel (12) für die Leitung mit einem Bereich der Wandung des Führungskanals in der Nähe dessen Mündungsöffnung (10) zusammenwirkend angeordnet sind.

2. Werkzeug nach Anspruch 1, **dadurch gekennzeichnet, daß** das Druckglied (19) im Bereiche der Druckfläche (22) einen auf die aus der Mündung (10) des Führungskanals austretende Leitung ausgerichteten Steg (24) aufweist, dessen Breite quer zu der Leitungsrichtung im wesentlichen kleiner/gleich dem Durchmesser der Leitung (5) ist.

3. Werkzeug nach Anspruch 2, **dadurch gekennzeichnet, daß** der Steg (24) wenigstens einseitig durch zumindest einen Bereich (23; 25) größerer Breite begrenzt ist.

4. Werkzeug nach Anspruch 2 oder 3, **dadurch gekennzeichnet, daß** auf wenigstens einer Seite des Steg (24) eine vorspringende Nase (25) angeordnet ist.

5. Werkzeug nach Anspruch 4, **dadurch gekennzeichnet, daß** der Bereich größerer Breite (23; 25) die gleiche Breite wie der Verlegefinger (2) aufweist.

6. Werkzeug nach einem der Ansprüche 2 bis 5, **dadurch gekennzeichnet, daß** der Steg (24) beidseitig durch Bereiche größerer Breite (23, 25) begrenzt ist, von denen einer (23) sich an eine die Mündungsöffnung (10) des Führungskanals (4) enthaltende Fläche (9) des Verlegefingers anschließt.

7. Werkzeug nach einem der vorhergehenden Ansprüche, **dadurch gekennzeichnet, dass** die Ablängmittel wenigstens ein an dem Verlegefinger (2) längsverschieblich geführtes Messer mit einer Messerklinge (12) aufweisen, dessen Messerklinge oberhalb eines im wesentlichen horizontalen Teiles des Führungskanales (4) beweglich angeordnet ist.

8. Werkzeug nach Anspruch 7, **dadurch gekennzeichnet, daß** die Messerklinge (12) wenigstens eine schräg zu der zugeordneten Wand des Führungskanals (4) verlaufende Schneidkante (14) aufweist.

9. Werkzeug nach Anspruch 8, **dadurch gekennzeichnet, daß** die Messerklinge eine auf die zugeordnete Wand des Führungskanals aufpreßbare Schneidkantenspitze (18) aufweist.

10. Werkzeug nach Anspruch 9, **dadurch gekennzeichnet, daß** die Schneidkantenspitze (18) in der Nähe der Mündung (10) des Führungkanals liegt.

11. Werkzeug nach Anspruch 7, **dadurch gekennzeichnet, daß** die Messerklinge (12) an das Druckglied (19) anschließend an dem Verlegefinger (2) und/oder dem Druckglied (19) verschieblich gelagert ist.

12. Werkzeug nach einem der Ansprüche 2 bis 11, **dadurch gekennzeichnet, daß** das Druckglied (19) mehrteilig ausgebildet ist und daß jedem seiner Teile ein eigener Druckflächenabschnitt zugeordnet ist.

## Claims

1. Tool for positioning and cutting to length electrical wires, having a housing (1) fitted for connection to positioning means, e.g. an industrial robot, having a positioning finger (2) disposed on a working side of the housing, in which finger a guide duct (4) having a lateral outlet opening is formed for a wire (5), and also having feed and cutting means for the wire, said tool having a pressing element (19), which is disposed in the vicinity of the outlet opening (10) of the guide duct for the wire exiting from the opening of the guide duct and which is movably located for movement transversely to the axial direction of the guide duct in the region of the outlet opening and is coupled to its own position control means (21), by means of which it may be displaced between a position removed from the outlet opening and a working position, **characterised in that**
in the working position, the pressing element (19) with a pressure surface (22) projects beyond the edge of the outlet opening of the guide duct (4) or is flush with the upper side of the edge of the outlet opening,
that the pressing element (19) adjoining a surface (9) containing the outlet opening (10) is disposed on the positioning finger (2) to be longitudinally slidable, and
that the longitudinally slidable cutting means (12) for the wire are arranged to cooperate with a region of the wall of the guide duct in the vicinity of its outlet opening (10).

2. Tool according to Claim 1, **characterised in that** in the region of the pressure surface (22), the pressing element (19) has a rib (24) aligned with the wire exiting from the outlet opening (10) of the guide duct, the width of said rib, transversely to the wire direction, being essentially smaller than/equal to the diameter of the wire (5).

3. Tool according to Claim 2, **characterised in that** the rib (24) is bordered on at least one side by at least one region (23; 25) of greater width.

4. Tool according to Claim 2 or 3, **characterised in that** a projecting nose (25) is disposed on at least one side of the rib (24).

5. Tool according to Claim 4, **characterised in that** the region of greater width (23; 25) has the same width as the positioning finger (2).

6. Tool according to one of Claims 2 to 5, **characterised in that** the rib (24) is bordered on both sides by regions of greater width (23, 25), of which one (23) adjoins an area (9) of the positioning finger containing the outlet opening (10) of the guide duct (4).

7. Tool according to one of the preceding claims, **characterised in that** the cutting means have at least one knife disposed to be longitudinally slidable on the positioning finger (2) having a blade element (12), its blade element being movably disposed above an essentially horizontal portion of the guide duct (4).

8. Tool according to Claim 7, **characterised in that** the blade element (12) has at least one cutting edge (14) extending at an inclination to the associated wall of the guide duct (4).

9. Tool according to Claim 8, **characterised in that** the blade element has a cutting tip (18) which may be pressed onto the associated wall of the guide duct.

10. Tool according to Claim 9, **characterised in that** the cutting tip (18) is located in the vicinity of the outlet opening (10) of the guide duct.

11. Tool according to Claim 7, **characterised in that** the blade element (12) adjoining the pressing element (19) is disposed to slide on the positioning finger (2) and/or the pressing element (19).

12. Tool according to one of Claims 2 to 11, **characterised in that** the pressing element (19) is constructed of multiple parts, and that each of its parts is assigned its own pressure surface portion.

## Revendications

1. Outil de pose et, le cas échéant, de coupe de conducteurs électriques, comprenant un boîtier (1) agencé en vue de sa liaison avec des moyens de pose, par exemple avec un robot industriel, avec, disposé sur une face de travail du boîtier, un doigt de pose (2) dans lequel est aménagé un canal de guidage (4) pour un conducteur (5), muni d'une embouchure latérale, ainsi qu'avec des moyens d'avance et de coupe du conducteur, l'outil comportant un élément presseur (19) pour le conducteur sortant de l'embouchure du canal de guidage, qui est disposé dans la région de l'embouchure (10) du canal de guidage, est monté mobile dans la région de l'embouchure, transversalement à la direction axiale du canal de guidage et est couplé à des moyens de déplacement (21) propres, grâce auxquels il peut être déplacé entre une position éloignée de l'embouchure et une position de travail, **caractérisé en ce que** l'élément presseur (19), dans la position de travail, par une surface de pression (22), s'étend au-delà du bord de l'embouchure du canal de guidage (4) ou est aligné avec la face supérieure du bord de l'embouchure, **en ce que** l'élément presseur (19), dans le prolongement d'une surface (9) contenant l'ouverture de l'embouchure (10), est guidé de manière coulissante dans la direction longitudinale sur le doigt de pose (2) et **en ce que** le moyen de coupe (12) du conducteur, guidé de manière coulissante, est disposé de manière à coopérer avec une partie de la paroi du canal de guidage, dans la région de l'ouverture d'embouchure (10) de celui-ci.

2. Outil selon la revendication 1, **caractérisé en ce que** l'élément presseur (19) dans la région de la surface de pression (22) présente une cloison (24) dirigée vers le conducteur sortant de l'embouchure (10) du canal de guidage, dont la largeur mesurée transversalement à la direction du conducteur est essentiellement inférieure/égale au diamètre du conducteur (5).

3. Outil selon la revendication 2, **caractérisé en ce que** la cloison (24), d'un côté au moins, est limitée par une zone (23, 25) de largeur plus grande.

4. Outil selon la revendication 2 ou 3, **caractérisé en ce qu'**un bec saillant (25) est prévu d'un côté au moins de la cloison (24).

5. Outil selon la revendication 4, **caractérisé en ce que** la zone (23, 25) de largeur plus grande a la même largeur que le doigt de pose (2).

6. Outil selon une des revendications 2 à 5, **caractérisé en ce que** la cloison (24), est limitée des deux côtés par des zones (23, 25) de plus grande largeur, parmi lesquelles l'une se raccorde à une surface (9) du doigt de pose, contenant l'embouchure (10) du canal de guidage (4).

7. Outil selon une des revendications précédentes, **caractérisé en ce que** les moyens de coupe comprennent au moins un couteau avec une lame (12), guidé de manière coulissante dans la direction longitudinale sur le doigt de pose (2), dont la lame est montée mobile au-dessus d'un tronçon essentiellement horizontal du canal de guidage (4).

8. Outil selon la revendication 7, **caractérisé en ce que** la lame de couteau (12) comporte au moins un tranchant (14) incliné par rapport à la paroi associée du canal de guidage (4).

9. Outil selon la revendication 8, **caractérisé en ce que** la lame de couteau présente une pointe (18) de tranchant qui peut être pressée contre la paroi associée du canal de guidage.

10. Outil selon la revendication 9, **caractérisé en ce que** la pointe (18) de tranchant est disposée dans le voisinage de l'embouchure (10) du canal de guidage.

11. Outil selon la revendication 7, **caractérisé en ce que** la lame de couteau (12) est montée coulissante sur le doigt de pose (2) et/ou l'élément presseur (19), à la suite de l'élément presseur (19).

12. Outil selon une des revendications 2 à 11, **caractérisé en ce que** l'élément presseur (19) est réalisé en plusieurs parties et **en ce qu'**à chacune des parties est associée une portion de surface de pression.
